(19) Europäisches Patentamt / European Patent Office / Office européen des brevets

(11) **EP 3 796 383 A1**

(12) **EUROPEAN PATENT APPLICATION**
published in accordance with Art. 153(4) EPC

(43) Date of publication:
**24.03.2021 Bulletin 2021/12**

(51) Int Cl.:
***H01L 27/04*** *(2006.01)*      ***H01L 21/02*** *(2006.01)*

(21) Application number: **19920639.2**

(86) International application number:
**PCT/CN2019/098020**

(22) Date of filing: **26.07.2019**

(87) International publication number:
**WO 2021/016764 (04.02.2021 Gazette 2021/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Shenzhen Goodix Technology Co., Ltd. Shenzhen, Guangdong 518045 (CN)**

(72) Inventors:
- **LU, Bin**
  **Guangdong 518045 (CN)**
- **SHEN, Jian**
  **Guangdong 518045 (CN)**
- **PI, Bo**
  **Guangdong 518045 (CN)**

(74) Representative: **Pfenning, Meinig & Partner mbB Patent- und Rechtsanwälte Theresienhöhe 11a 80339 München (DE)**

(54) **CAPACITANCE DEVICE AND MANUFACTURING METHOD THEREFOR**

(57)      Embodiments of the application provide a capacitive apparatus and a method for producing the same. The capacitive apparatus includes at least one capacitor; where the at least one capacitor includes at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient. Using a principle of positive and negative cancellation, when the at least one capacitor is regarded as a whole, a voltage coefficient and/or a temperature coefficient thereof may be zero or close to zero. Thus, when a bias voltage or a temperature of the at least one capacitor changes, a capacitance value thereof does not change or changes slightly, thereby effectively ensuring the performance of the capacitive apparatus.

FIG. 1

EP 3 796 383 A1

**Description**

**TECHNICAL FIELD**

The present application relates to the field of capacitors, and in particular, to a capacitive apparatus and a method for producing the same.

**BACKGROUND**

A capacitor may play a role of bypassing, filtering, decoupling, or the like in a circuit, which is an indispensable part of ensuring a normal operation of the circuit. A capacitance value of an actually produced capacitor changes with the magnitude of a bias voltage across both ends thereof or a temperature thereof.

Specifically, the change of the capacitance value of the capacitor with the bias voltage may be characterized by the following equation:

$$C(V) = C_0 \left( \alpha \cdot V^2 + \beta \cdot V + 1 \right).$$

$C_0$ represents a capacitance value of a capacitor under a bias voltage of zero volts (V), $\alpha$ is a secondary voltage coefficient of the capacitor, and $\beta$ is a primary voltage coefficient of the capacitor, which is also referred to as a linear coefficient.

Similarly, the change of the capacitance value of the capacitor with the temperature may be characterized by the following equation:

$$C(T) = C_{25} \left( \gamma \cdot (T - 25) + 1 \right).$$

$C_{25}$ is a capacitance value of the capacitor at 25 degrees Celsius (°C), and $\gamma$ is a temperature coefficient of the capacitor.

The voltage coefficient and the temperature coefficient of the capacitor may be positive or negative according to different dielectric materials used.

In the prior art, a material with a positive voltage coefficient and a material with a negative voltage coefficient are generally mixed uniformly to form a dielectric material with a voltage coefficient close to zero, and/or a material with a positive temperature coefficient and a material with a negative temperature coefficient are generally mixed uniformly to form a dielectric material with a temperature coefficient close to zero, and thus a capacitor with a voltage coefficient and/or a temperature coefficient close to zero is produced to improve performance of the capacitor. For example, NPO type multilayer ceramic capacitors (Multilayer Ceramic Capacitors, MLCC).

However, it is difficult to produce a capacitor with a coefficient close to zero by mixing materials with different coefficients, due to higher process requirements.

Therefore, there is an urgent need in the art for a new capacitor with a voltage coefficient and/or a temperature coefficient close to zero.

**SUMMARY**

Embodiments of the present application provide a capacitive apparatus and a method for producing the same, which could reduce a voltage coefficient and/or a temperature coefficient of the capacitive apparatus.

In a first aspect, a capacitive apparatus is provided, including:

at least one capacitor;
where the at least one capacitor includes at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient.

The positive voltage coefficient of the first dielectric layer cancels out the negative voltage coefficient of the second dielectric layer, so that a voltage coefficient of the at least one capacitor may be zero or close to zero. Similarly, the positive temperature coefficient of the first dielectric layer cancels out the negative temperature coefficient of the second dielectric layer, so that a voltage coefficient of the at least one capacitor may be zero or close to zero. That is, using a principle of positive and negative cancellation, when the at least one capacitor is regarded as a whole, a voltage coefficient and/or a temperature coefficient thereof may be zero or close to zero.

Thus, when a bias voltage or a temperature of the at least one capacitor changes, a capacitance value thereof does not change or changes slightly, thereby effectively ensuring the performance of the capacitive apparatus.

In some possible embodiments, the positive voltage coefficient of the first dielectric layer and the negative voltage coefficient of the second dielectric layer enable a voltage coefficient of the at least one capacitor to be zero or close to zero; and/or the positive temperature coefficient of the first dielectric layer and the negative temperature coefficient of the second dielectric layer enable a temperature coefficient of the at least one capacitor to be zero or close to zero.

In some possible embodiments, the at least one capacitor includes:

at least two capacitors connected in parallel;
where the at least two capacitors include at least one first capacitor and at least one second capacitor, and the first capacitor has a positive voltage coefficient and the second capacitor has a negative voltage coefficient, so that a voltage coefficient of the at least two capacitors is zero or close to zero; and/or the first capacitor has a positive temperature coefficient and the second capacitor has a negative temperature coefficient, so that a temperature coefficient of the at least two capacitors is zero or close to zero.

That is, the voltage coefficient of the first capacitor cancels out the voltage coefficient of the second capacitor and/or the temperature coefficient of the first capacitor cancels out the temperature coefficient of the second capacitor, so that when the at least two capacitors connected in parallel are regarded as a whole, a voltage coefficient and/or a temperature coefficient thereof is zero or close to zero.

Thus, when a bias voltage or a temperature of the at least two capacitors changes, a capacitance value thereof does not change or changes slightly, thereby effectively ensuring the performance of the capacitive apparatus.

In some possible embodiments, the first dielectric layer includes a first silicon dioxide ($SiO_2$) layer, a second $SiO_2$ layer and a first hafnium oxide ($HfO_2$) layer, where the first $HfO_2$ layer is disposed between the first $SiO_2$ layer and the second $SiO_2$ layer; and the second dielectric layer includes a third $SiO_2$ layer, a fourth $SiO_2$ layer and an yttrium oxide ($Y_2O_3$) layer, where the $Y_2O_3$ layer is disposed between the third $SiO_2$ layer and the fourth $SiO_2$ layer.

As a voltage coefficient of $Y_2O_3$ is negative and a voltage coefficient of $HfO_2$ is positive, $Y_2O_3$ and $HfO_2$ are respectively used as dielectric layers in two capacitors, so that when the two capacitors are regarded as a whole, a voltage coefficient thereof may be zero or close to zero.

Thus, when a bias voltage or a temperature of the two capacitors changes, a capacitance value thereof does not change or changes slightly, thereby effectively ensuring the performance of the capacitive apparatus.

In addition, $Y_2O_3$ and $HfO_2$ belong to high dielectric constant (high-k) materials, and a band gap thereof is small, which easily causes excessive leakage of the capacitor. Therefore, $SiO_2$ with a wide band gap is placed on upper and lower surfaces of the high-k materials, which could reduce the leakage of the capacitor and ensure the comprehensive performance of the capacitor.

In some possible embodiments, a number of the at least one first capacitor is equal to a number of the at least one second capacitor.

In some possible embodiments, the at least one capacitor includes:
a third capacitor, where dielectric layers of the third capacitor include the first dielectric layer and the second dielectric layer, so that a voltage coefficient and/or a temperature coefficient of the third capacitor is zero or close to zero.

That is, the voltage coefficient of the first dielectric layer cancels out the voltage coefficient of the second dielectric layer, and/or the temperature coefficient of the first dielectric layer cancels out the temperature coefficient of the second dielectric layer, so that when the dielectric layers of the third capacitor are regarded as a whole, a voltage coefficient and/or a temperature coefficient thereof is zero or close to zero.

Thus, when a bias voltage or a temperature of the third capacitor changes, a capacitance value of the third capacitor does not change or changes slightly, thereby effectively ensuring the performance of the capacitive apparatus.

In some possible embodiments, the first dielectric layer includes a fifth silicon dioxide ($SiO_2$) layer and a sixth $SiO_2$ layer, and the second dielectric layer includes a second hafnium dioxide ($HfO_2$) layer, where the second $HfO_2$ layer is disposed between the fifth $SiO_2$ layer and the sixth $SiO_2$ layer.

In some possible embodiments, the at least one capacitor is at least one capacitor formed by a laminated structure.

The laminated structure is provided with layers with different temperature coefficients and/or voltage coefficients, so that when the laminated structure is regarded as a whole, a voltage coefficient and/or a temperature coefficient thereof may be zero or close to zero, thereby ensuring the performance of the capacitive apparatus.

In some possible embodiments, the laminated structure includes:

a plurality of dielectric layers and at least one conductive layer that are disposed above the substrate; where the plurality of dielectric layers and the at least one conductive layer form a structure that a dielectric layer and a conductive layer are adjacent to each other.

In some possible embodiments, the substrate is a conductive substrate, or a surface of the substrate close to the laminated structure is provided with a conductive region with a resistivity lower than a preset threshold value, and a bottom layer of the laminated structure close to the substrate is a dielectric layer in the plurality of dielectric layers.

In some possible embodiments, the substrate is an insulating substrate, and a bottom layer of the laminated structure close to the substrate is a conductive layer in the at least one conductive layer.

In some possible embodiments, a surface of the substrate close to the laminated structure is provided with at least one groove, and at least a portion of the laminated structure is disposed in the at least one groove.

In some possible embodiments, a bottom conductive layer of the at least one conductive layer close to the substrate or a bottom dielectric layer of the plurality of dielectric layers close to the substrate forms at least one of following structures:
a trench structure, a pillar structure, or a wall structure.

In a second aspect, a method for producing a capacitive apparatus is provided, including:

producing at least one capacitor;
where the at least one capacitor includes at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient.

In some possible embodiments, the positive voltage coefficient of the first dielectric layer and the negative voltage coefficient of the second dielectric layer enable a voltage coefficient of the at least one capacitor to be zero or close to zero; and/or the positive temperature coefficient of the first dielectric layer and the negative temperature coefficient of the second dielectric layer enable a temperature coefficient of the at least one capacitor to be zero or close to zero.

In some possible embodiments, the producing at least one capacitor includes:

producing at least two capacitors connected in parallel;
where the at least two capacitors include at least one first capacitor and at least one second capacitor, and the first capacitor has a positive voltage coefficient and the second capacitor has a negative voltage coefficient, so that a voltage coefficient of the at least two capacitors is zero or close to zero; and/or the first capacitor has a positive temperature coefficient and the second capacitor has a negative temperature coefficient, so that a temperature coefficient of the at least two capacitors is zero or close to zero.

In some possible embodiments, the first dielectric layer includes a first silicon dioxide ($SiO_2$) layer, a second $SiO_2$ layer and a first hafnium oxide ($HfO_2$) layer, where the first $HfO_2$ layer is disposed between the first $SiO_2$ layer and the second $SiO_2$ layer; and the second dielectric layer includes a third $SiO_2$ layer, a fourth $SiO_2$ layer and an yttrium oxide ($Y_2O_3$) layer, where the $Y_2O_3$ layer is disposed between the third $SiO_2$ layer and the fourth $SiO_2$ layer.

In some possible embodiments, a number of the at least one first capacitor is equal to a number of the at least one second capacitor.

In some possible embodiments, the producing at least one capacitor includes:
producing a third capacitor, where dielectric layers of the third capacitor include the first dielectric layer and the second dielectric layer, so that a voltage coefficient and/or a temperature coefficient of the third capacitor is zero or close to zero.

In some possible embodiments, the first dielectric layer includes a fifth silicon dioxide ($SiO_2$) layer and a sixth $SiO_2$ layer, and the second dielectric layer includes a second hafnium dioxide ($HfO_2$) layer, where the second $HfO_2$ layer is disposed between the fifth $SiO_2$ layer and the sixth $SiO_2$ layer.

In some possible embodiments, the at least one capacitor is at least one capacitor formed by a laminated structure.

In some possible embodiments, the producing at least one capacitor includes:

producing a plurality of dielectric layers and at least one conductive layer that are disposed above a substrate;
where the plurality of dielectric layers and the at least one conductive layer form a structure that a dielectric layer and a conductive layer are adjacent to each other.

In some possible embodiments, the substrate is a conductive substrate, or a surface of the substrate close to the laminated structure is provided with a conductive region with a resistivity lower than a preset threshold value, and a bottom layer of the laminated structure close to the substrate is a dielectric layer in the plurality of dielectric layers.

In some possible embodiments, the substrate is an insulating substrate, and a bottom layer of the laminated structure close to the substrate is a conductive layer in the at least one conductive layer.

In some possible embodiments, a surface of the substrate close to the laminated structure is provided with at least one groove, and at least a portion of the laminated structure is disposed in the at least one groove.

In some possible embodiments, a bottom conductive layer of the at least one conductive layer close to the substrate or a bottom dielectric layer of the plurality of dielectric layers close to the substrate forms at least one of following structures:
a trench structure, a pillar structure, or a wall structure.

In a third aspect, a capacitive apparatus is provided, including:
the capacitive apparatus produced by the method according to the second aspect or any one of the possible embodiments of the second aspect.

**BRIEF DESCRIPTION OF THE DRAWINGS**

FIG. 1 is a schematic block diagram of a capacitive apparatus according to an embodiment of the present application.
FIG. 2 is an equivalent circuit diagram of two capacitors connected in parallel according to an embodiment of the present application.
FIG. 3 is a schematic diagram of a curve of a capacitance value of a capacitor changing with a voltage value.

FIGS. 4 to 5 are schematic block diagrams of modified structures of the capacitive apparatus shown in FIG. 1.

FIGS. 6 to 11 are schematic flow charts of a method for producing the capacitive apparatus shown in FIG. 1 according to an embodiment of the present application.

## DESCRIPTION OF EMBODIMENTS

Technical solutions in embodiments of the present application will be described hereinafter with reference to the accompanying drawings.

It should be understood that a capacitive apparatus of an embodiment of the present application may play a role of bypassing, filtering, decoupling, or the like in a circuit.

The capacitive apparatus described in the embodiment of the present application may be a 3D silicon capacitor, which may be a capacitor processed by semiconductor wafer processing technology.

Compared with a multilayer ceramic capacitor (Multilayer ceramic capacitor, MLCC), the 3D silicon capacitor has advantages of small size, high precision, strong stability, and long lifetime. In a processing flow of the 3D silicon capacitor, a 3D structure with a high depth-to-width ratio such as a via (Via), a trench (Trench), a pillar (Pillar) shape, a wall (Wall) shape, or the like is required to be first processed on a wafer or substrate, and then an insulating film and a low-resistivity conductive material are deposited on a surface of the 3D structure to produce a lower electrode, a dielectric layer and an upper electrode of the capacitor, sequentially.

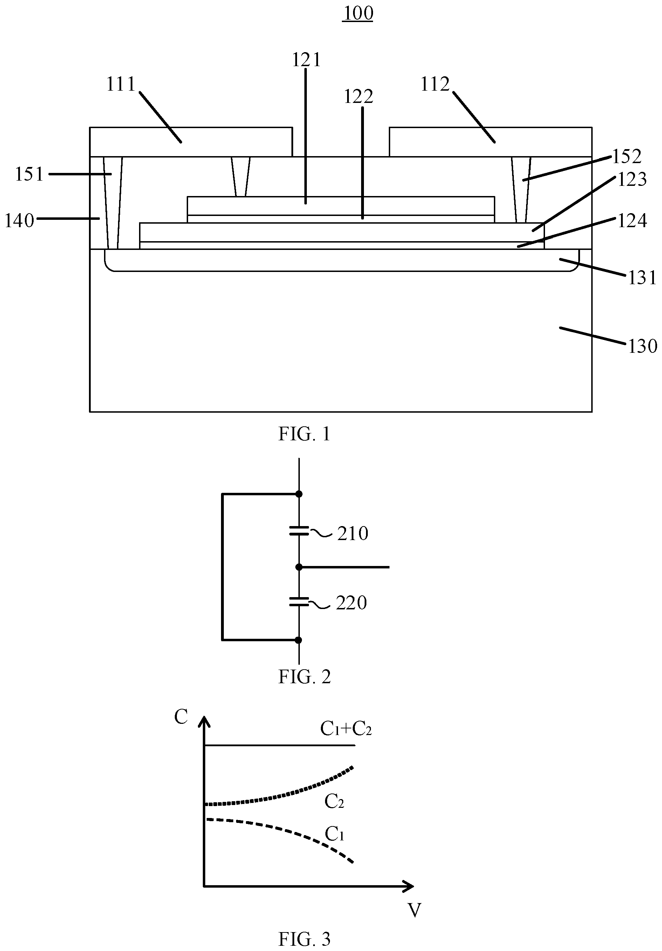

Hereinafter, a capacitive apparatus and a method for producing the same according to the present application will be introduced in detail with reference to FIGS. 1 to 11.

It should be noted that, for convenience of description, in the embodiments of the present application, the same reference numeral represents the same component, and a detailed explanation for the same component is omitted in different embodiments for the sake of brevity. It should be understood that dimensions such as thicknesses, lengths and widths of various components in embodiments of the present application shown in the drawings, as well as dimensions of the overall thickness, length and width of an integrated apparatus are merely illustrative, and should not constitute any limitation to the present application.

In addition, to facilitate understanding, in the embodiments shown below, for structures shown in different embodiments, the same structure is denoted by the same reference number, and a detailed explanation for the same structure is omitted for the sake of brevity.

Embodiments of the present application provide a capacitive apparatus and a method for producing the same, which could reduce a voltage coefficient and/or a temperature coefficient of the capacitor.

Optionally, the capacitive apparatus may include at least one capacitor.

The at least one capacitor includes at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient.

That is, the voltage coefficient of the first capacitor cancels out the voltage coefficient of the second capacitor and/or the temperature coefficient of the first capacitor cancels out the temperature coefficient of the second capacitor, so that when the at least two capacitors connected in parallel are regarded as a whole, a voltage coefficient and/or a temperature coefficient thereof is zero or close to zero.

Thus, when a bias voltage or a temperature of the at least two capacitors changes, a capacitance value thereof does not change or changes slightly, thereby effectively ensuring the performance of the capacitive apparatus.

In other words, the positive voltage coefficient of the first dielectric layer and the negative voltage coefficient of the second dielectric layer enable a voltage coefficient of the at least one capacitor to be zero or close to zero; and/or the positive temperature coefficient of the first dielectric layer and the negative temperature coefficient of the second dielectric layer enable a temperature coefficient of the at least one capacitor to be zero or close to zero.

It should be understood that the coefficient close to zero may refer to that the coefficient is substantively zero, and at this time, when the bias voltage and/or temperature of the capacitor changes, the capacitance value thereof does not change or changes slightly.

In some embodiments of the present application, the at least one capacitor may include:

at least two capacitors connected in parallel; where the at least two capacitors include at least one first capacitor and at least one second capacitor, and the first capacitor has a positive voltage coefficient and the second capacitor has a negative voltage coefficient, so that a voltage coefficient of the at least two capacitors is zero or close to zero; and/or the first capacitor has a positive temperature coefficient and the second capacitor has a negative temperature coefficient, so that a temperature coefficient of the at least two capacitors is zero or close to zero.

FIG. 1 is a schematic block diagram of a capacitive apparatus 100 according to an embodiment of the present application.

Referring to FIG. 1, the capacitive apparatus 100 may include a first capacitor and a second capacitor, where the first capacitor may be formed by a conductive region 131 formed on an upper surface of a substrate 130, a first dielectric layer 124 and a first conductive layer 123, and the second capacitor may be formed by the first conductive layer 123, a second dielectric layer 122 and a second conductive layer 121. Further, a first electrode 111 is electrically connected to the conductive region 131 and the second conductive layer 121 through a first via 151 in an insulating layer 140, and a second electrode 112 is electrically connected to the first conductive layer 123 through a second via 152 in the insulating layer 140, so that the first capacitor is connected in parallel with the second capacitor, thereby forming a large capacitor.

The first dielectric layer 124 may be formed of a material with a positive voltage coefficient, and the second dielectric layer 122 may be formed of a material with a negative voltage coefficient, so that a voltage coefficient of the capacitive apparatus 100 is zero or close to zero; and/or, the first dielectric layer 124 may be formed of a material with a positive temperature coefficient, and the second dielectric layer 122 may be formed of a material with a negative temperature coefficient, so that a temperature coefficient of the at least two capacitors is zero or close to zero. FIG. 2 is an equivalent circuit diagram of the capacitive apparatus 100 shown in FIG. 1.

Referring to FIG. 2, the capacitive apparatus 100 may include a first capacitor 210 and a second capacitor 220 connected in parallel.

FIG. 3 is a schematic diagram of a curve of a capacitance value of a capacitor changing with a voltage value.

Referring to FIG. 3, it is assumed that a capacitance value $C_i$ of the first capacitor 210 increases with the increase of a bias voltage V across both ends thereof, and a capacitance value $C_2$ of the second capacitor 220 decreases with the increase of a bias voltage V across both ends thereof, however when the capacitive apparatus 100 is regarded as a whole, a capacitance value thereof does not change with a bias voltage V across both ends thereof, thus effectively ensuring the performance of the capacitive apparatus.

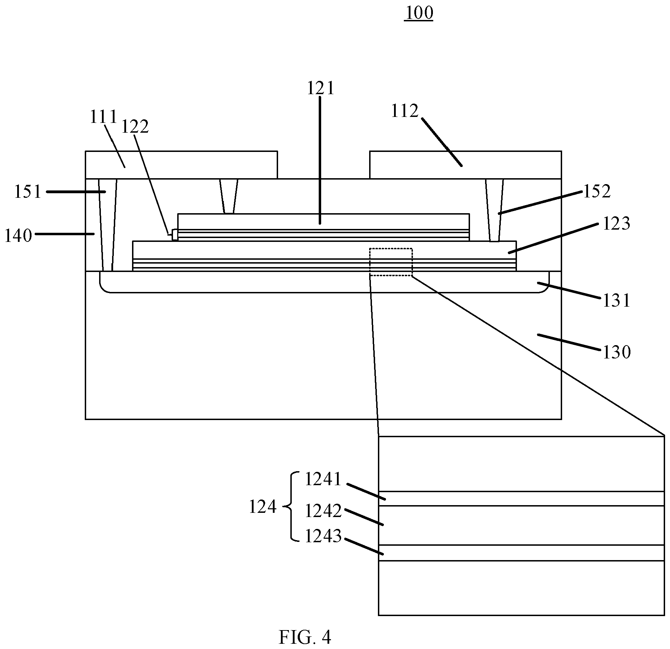

FIG. 4 is a schematic structural diagram of a modified structure of the capacitive apparatus 100 shown in FIG. 1.

Referring to FIG. 4, the first dielectric layer 124 may include a first silicon dioxide $SiO_2$ layer 1241, a second $SiO_2$ layer 1243 and a first hafnium oxide $Hf02$ layer 1242, where the first $HfO_2$ layer is disposed between the first $SiO_2$ layer and the second $SiO_2$ layer. Similarly, the second dielectric layer 122 may include a third $SiO_2$ layer, a fourth $SiO_2$ layer and an yttrium oxide $Y_2O_3$ layer, where the $Y_2O_3$ layer is disposed between the third $SiO_2$ layer and the fourth $SiO_2$ layer.

As a voltage coefficient of $Y_2O_3$ is negative and a voltage coefficient of $HfO_2$ is positive, $Y_2O_3$ and $HfO_2$ are respectively used as dielectric layers in two capacitors, so that when the two capacitors are regarded as a whole, a voltage coefficient thereof may be zero or close to zero.

Thus, when a bias voltage or a temperature of the two capacitors changes, a capacitance value thereof does not change or changes slightly, thereby effectively ensuring the performance of the capacitive apparatus.

In addition, $Y_2O_3$ and $HfO_2$ belong to high dielectric constant (high-k) materials, and a band gap thereof is small, which easily causes leakage of the capacitor. Therefore, $SiO_2$ with a wide band gap is placed on upper and lower surfaces of the high-k materials, which could reduce the leakage of the capacitor and ensure the comprehensive performance of the capacitor.

Further, the capacitive apparatus 100 may be formed by an even number of capacitors connected in parallel. For example, a number of the at least one first capacitor is equal to a number of the at least one second capacitor to ensure that the voltage coefficient and/or the temperature coefficient of the capacitive apparatus 100 is zero or close to zero. Of course, the capacitive apparatus 100 may also be formed by an odd number of capacitors connected in parallel, which is not specifically limited in the embodiment of the present application.

In some other embodiments of the present application, the at least one capacitor includes:

a third capacitor, where dielectric layers of the third capacitor include the first dielectric layer and the second dielectric layer, so that a voltage coefficient and/or a temperature coefficient of the third capacitor is zero or close to zero.

That is, the voltage coefficient of the first dielectric layer cancels out the voltage coefficient of the second dielectric layer, and/or the temperature coefficient of the first dielectric layer cancels out the temperature coefficient of the second dielectric layer, so that when the dielectric layers of the third capacitor are regarded as a whole, a voltage coefficient and/or a temperature coefficient thereof is zero or close to zero.

Thus, when a bias voltage or a temperature of the third capacitor changes, a capacitance value of the third capacitor does not change or changes slightly, thereby effectively ensuring the performance of the capacitive apparatus.

For example, the first dielectric layer includes a fifth $SiO_2$ layer and a sixth $SiO_2$ layer, and the second dielectric layer includes a second $HfO_2$ layer, where the second $HfO_2$ layer is disposed between the fifth $SiO_2$ layer and the sixth $SiO_2$ layer.

As a voltage coefficient of $SiO_2$ is negative and a voltage coefficient of $HfO_2$ is positive, a laminated layer formed by $SiO_2$ and $HfO_2$ is used as a dielectric layer of the third capacitor, so that a voltage coefficient of the third capacitor may be zero or close to zero.

In addition, $HfO_2$ belongs to a high dielectric constant (high-k) material, and a band gap thereof is small, which easily causes excessive leakage of the capacitor. Therefore, $SiO_2$ with a wide band gap is placed on upper and lower surfaces of the $HfO_2$ layer, which could reduce the leakage of the capacitor and ensure the comprehensive performance of the capacitor.

Of course, in other alternative embodiments, the foregoing at least two capacitors and the foregoing third capacitor may be connected in parallel to form a capacitive apparatus with a large capacitance value, which is not specifically limited in the embodiment of the present application.

In some embodiments of the present application, the at least one capacitor is at least one capacitor formed by a laminated structure.

The laminated structure is provided with layers with different temperature coefficients and/or voltage coefficients, so that when the laminated structure is regarded as a whole, a voltage coefficient and/or a temperature coefficient thereof may be zero or close to zero, thereby ensuring the performance of the capacitive apparatus.

In some embodiments of the present application, the laminated structure may include a plurality of dielectric layers and at least one conductive layer that are disposed over a substrate, where the plurality of dielectric layers and the at least one conductive layer form a structure that a dielectric layer and a conductive layer are adjacent to each other.

For example, the plurality of dielectric layers includes at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient.

In some embodiments of the present application, the substrate is a conductive substrate, or a surface of the substrate close to the laminated structure is provided with a conductive region with a resistivity lower than a preset threshold value, and a bottom layer of the laminated structure close to the substrate is a dielectric layer in the plurality of dielectric layers.

In some embodiments of the present application, the substrate is an insulating substrate, and a bottom layer of the laminated structure close to the substrate is a conductive layer in the at least one conductive layer.

In some embodiments of the present application, a surface of the substrate close to the laminated structure is provided with at least one groove, and at least a portion of the laminated structure is disposed in the at least one groove.

In some embodiments of the present application, a bottom conductive layer of the at least one conductive layer close to the substrate or a bottom dielectric layer of the plurality of dielectric layers close to the substrate forms at least one of following structures: a trench structure, a pillar structure, or a wall structure.

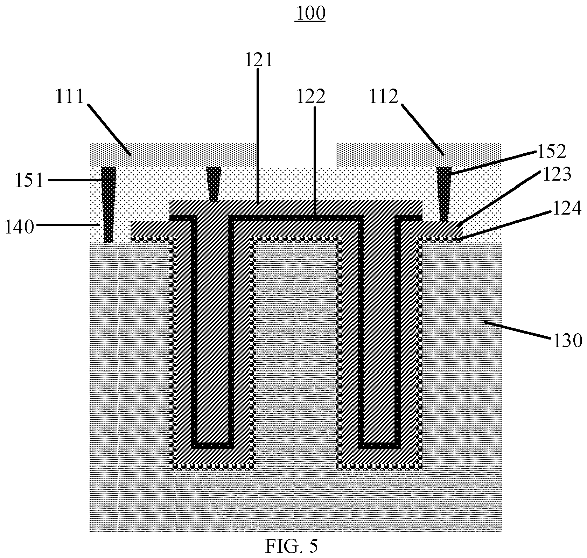

FIG. 5 is a schematic diagram of another modified structure of the capacitive apparatus 100 shown in FIG. 1.

Referring to FIG. 5, the capacitive apparatus 100 includes a conductive substrate 130, and an upper surface of the conductive substrate 130 extends downward to form at least one groove (for example, two grooves shown in FIG. 5). The capacitive apparatus 100 may include a first capacitor and a second capacitor, where the first capacitor may be formed by the conductive substrate 130, a first dielectric layer 124 and a first conductive layer 123, and the second capacitor may be formed by the first conductive layer 123, a second dielectric layer 122 and a second conductive layer 121. Further, a first electrode 111 is electrically connected to the conductive substrate 130 and the second conductive layer 121 through a first via 151 in an insulating layer 140, and a second electrode 112 is electrically connected to the first conductive layer 123 through a second via 152 in the insulating layer 140, so that the first capacitor is connected in parallel with the second capacitor, thereby forming a large capacitor.

The present application also provides a method for producing a capacitive apparatus, which could reduce a voltage coefficient and/or a temperature coefficient of the capacitive apparatus.

In some embodiments of the present application, the at least one capacitor is produced.

The at least one capacitor includes at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient.

In some embodiments of the present application, the positive voltage coefficient of the first dielectric layer and the negative voltage coefficient of the second dielectric layer enable a voltage coefficient of the at least one capacitor to be zero or close to zero; and/or the positive temperature coefficient of the first dielectric layer and the negative temperature coefficient of the second dielectric layer enable a temperature coefficient of the at least one capacitor to be zero or close to zero.

In some embodiments of the present application, the producing at least one capacitor includes:

producing at least two capacitors connected in parallel;
where the at least two capacitors include at least one first capacitor and at least one second capacitor, and the first capacitor has a positive voltage coefficient and the second capacitor has a negative voltage coefficient, so that a voltage coefficient of the at least two capacitors is zero or close to zero; and/or the first capacitor has a positive temperature coefficient and the second capacitor has a negative temperature coefficient, so that a temperature coefficient of the at least two capacitors is zero or close to zero.

In some embodiments of the present application, the first dielectric layer includes a first silicon dioxide $SiO_2$ layer, a second $SiO_2$ layer and a first hafnium oxide $HfO_2$ layer, where the first $HfO_2$ layer is disposed be-

tween the first $SiO_2$ layer and the second $SiO_2$ layer; and the second dielectric layer includes a third $SiO_2$ layer, a fourth $SiO_2$ layer and an yttrium oxide $Y_2O_3$ layer, where the $Y_2O_3$ layer is disposed between the third $SiO_2$ layer and the fourth $SiO_2$ layer.

In some embodiments of the present application, a number of the at least one first capacitor is equal to a number of the at least one second capacitor.

In some embodiments of the present application, the producing at least one capacitor includes: producing a third capacitor, where dielectric layers of the third capacitor include the first dielectric layer and the second dielectric layer, so that a voltage coefficient and/or a temperature coefficient of the third capacitor is zero or close to zero.

In some embodiments of the present application, the first dielectric layer includes a fifth silicon dioxide $SiO_2$ layer and a sixth $SiO_2$ layer, and the second dielectric layer includes a second hafnium dioxide $HfO_2$ layer, where the second $HfO_2$ layer is disposed between the fifth $SiO_2$ layer and the sixth $SiO_2$ layer.

In some embodiments of the present application, the at least one capacitor is at least one capacitor formed by a laminated structure.

In some embodiments of the present application, the producing at least one capacitor includes:

producing a plurality of dielectric layers and at least one conductive layer that are disposed above a substrate;
where the plurality of dielectric layers and the at least one conductive layer form a structure that a dielectric layer and a conductive layer are adjacent to each other.

In some embodiments of the present application, the substrate is a conductive substrate, or a surface of the substrate close to the laminated structure is provided with a conductive region with a resistivity lower than a preset threshold value, and a bottom layer of the laminated structure close to the substrate is a dielectric layer in the plurality of dielectric layers.

In some embodiments of the present application, the substrate is an insulating substrate, and a bottom layer of the laminated structure close to the substrate is a conductive layer in the at least one conductive layer.

In some embodiments of the present application, a surface of the substrate close to the laminated structure is provided with at least one groove, and at least a portion of the laminated structure is disposed in the at least one groove.

In some embodiments of the present application, a bottom conductive layer of the at least one conductive layer close to the substrate or a bottom dielectric layer of the plurality of dielectric layers close to the substrate forms at least one of following structures: a trench structure, a pillar structure, or a wall structure.

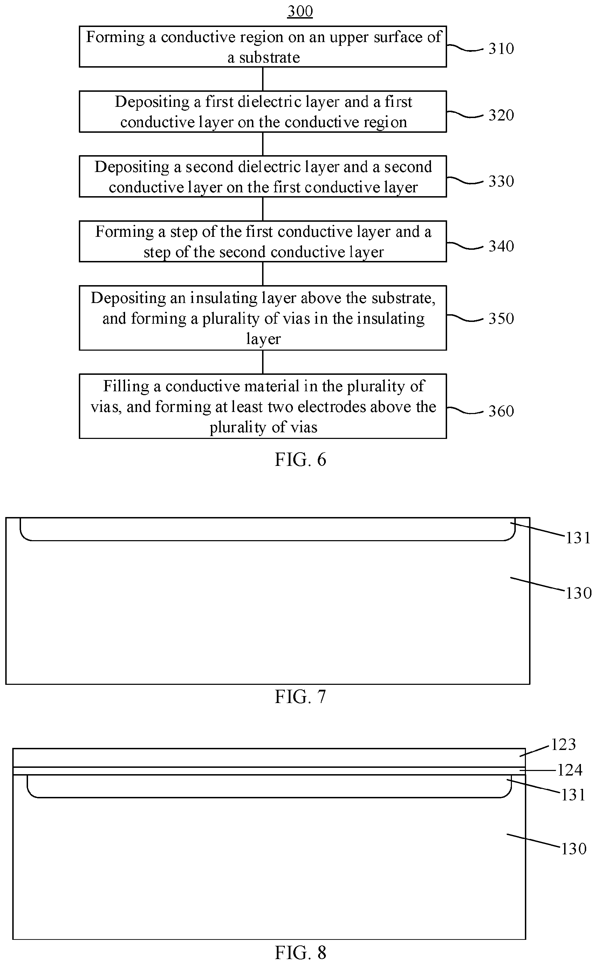

FIG. 6 is a schematic flow chart of a method 300 for producing a capacitive apparatus 100 according to an embodiment of the present application. FIGS. 7 to 11 are schematic block diagrams of respective structures formed in a process of producing the capacitive apparatus 100. A method for producing a capacitive apparatus according to an embodiment of the present application will be exemplarily illustrated with reference to FIGS. 6 to 11.

Referring to FIG. 6, the method 300 may include:
S310, a conductive region is formed on an upper surface of a substrate.

For example, referring to FIG. 7, a silicon wafer may be selected as a substrate 130, and doping is performed on a local region of an upper surface of the substrate 130 to form a low-resistivity conductive region 131. Of course, in other alternative embodiments, a conductive substrate may also be directly used, or doping may also be performed on an entire upper surface of the substrate, which is not specifically limited in an embodiment of the present application.

The substrate 130 may be a semiconductor substrate, a glass substrate, or an organic substrate whose surface is provided with a low-resistivity conductive layer. A material of the semiconductor substrate may be silicon, germanium, III-V elements (silicon carbide (SiC), gallium nitride (GaN), gallium arsenide (GaAs), or the like), or a combination of the foregoing different materials. The semiconductor substrate may also include an epitaxial layer structure of the substrate for insulating the substrate, such as a silicon-on-insulator (silicon-on-insulator, SOI) structure. The substrate 130 may be a whole piece of the wafer or a portion cut from the wafer.

S320, a first dielectric layer and a first conductive layer are deposited on the conductive region.

For example, referring to FIG. 8, a first dielectric layer 124 and a first conductive layer 123 are deposited on the conductive region 131, where the first dielectric layer 124 may have a negative voltage (temperature) coefficient or a positive voltage (temperature) coefficient.

A material of the first conductive layer 123 may be formed of a low-resistivity conductive material, which may be, for example, heavily doped polysilicon, a carbon material, or various metals such as aluminum (Al), tungsten (W), copper (Cu), titanium (Ti), tantalum (Ta), platinum (Pt), ruthenium (Ru), iridium (Ir), rhodium (Rh), or the like, or may be a low-resistivity compound such as titanium nitride and tantalum nitride, or a laminated layer or combination of the foregoing several conductive materials, which is not specifically limited in the embodiment of the present application.

S330, a second dielectric layer and a second conductive layer are deposited on the first conductive layer.

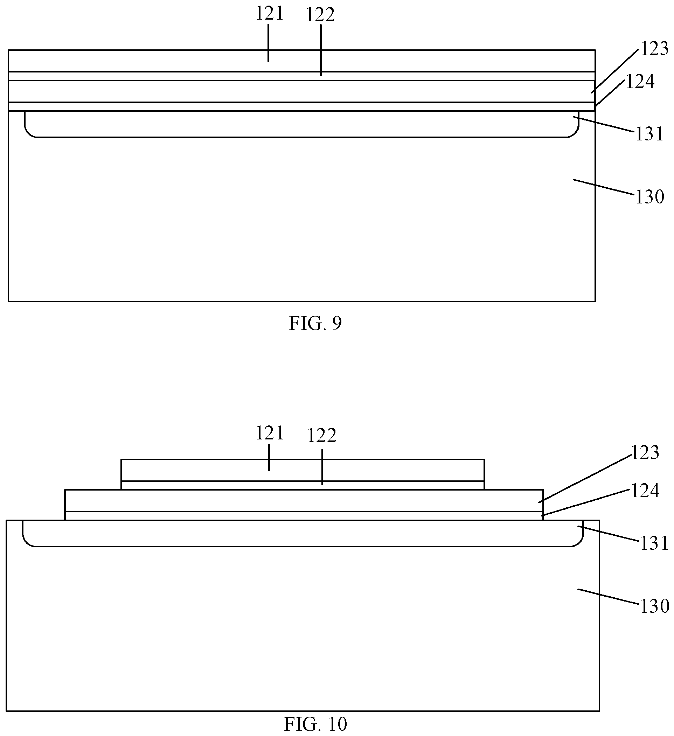

For example, referring to FIG. 9, a second dielectric layer 122 and a second conductive layer 121 are deposited on the first conductive layer 123, and when the first dielectric layer 124 has a negative voltage (temperature) coefficient, the second dielectric layer 122 has a positive voltage (temperature) coefficient; and when the first dielectric layer 124 has a positive voltage (temperature) coefficient, the second dielectric layer 122 has a negative voltage (temperature) coefficient.

A material of the second conductive layer 121 and a material of the first conductive layer 123 may be the same or different, which is not specifically limited in the present application.

S340, a step of the first conductive layer and a step of the second conductive layer are formed.

For example, referring to FIG. 10, the steps of the first conductive layer 123 and the second conductive layer 121 may be formed by a photolithography process, and the low-resistivity conductive region 131 of the substrate 130 is exposed.

S350, an insulating layer is deposited above the substrate, and a plurality of vias are formed in the insulating layer.

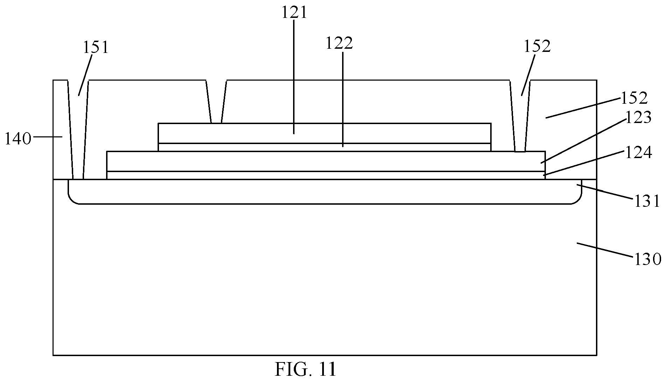

For example, referring to FIG. 11, an insulating layer 140 may be deposited above the substrate 130 as an interlayer dielectric layer for covering the substrate 130 and respective conductive layers. Further, a photolithography process may be combined with an etching process to form at least one first via 151 and at least one second via 152, where the first via 151 is configured to expose the conductive region 131 and the second conductive layer 121, and the second via 152 is configured to expose the first conductive layer 123.

A material of the first insulating layer 140 may be an organic polymer material, such as polyimide (Polyimide), parylene (Parylene), benzocyclobutene (BCB), or the like, it may also be some inorganic materials, such as spin on glass (Spin on glass, SOG), undoped silicon glass (Undoped Silicon Glass, USG), boro-silicate glass (Boro-silicate glass, BSG), phospho-silicate glass (phospho-silicate glass, PSG), boro-phospho-silicate glass (Boro-phospho-silicate glass, BPSG), silicon oxide synthesized by tetraethyl orthosilicate (Tetraethyl Orth silicate, TEOS), silicon oxide, silicon nitride and ceramic; and it may also be a laminated layer or combination of the foregoing materials.

S360, a conductive material is filled in the plurality of vias, and at least two electrodes are formed above the plurality of vias.

For example, referring to FIG. 1, a conductive material is filled in the first via 151 and the second via 152 to form conductive channels. Further, a first electrode 111 and a second electrode 112 are respectively produced above the first via 151 and the second via 152, where the first electrode 111 is connected to the low resistivity-conductive region 131 of the substrate 130 and the second conductive layer 121 through a conductive channel formed by the first via 151, and the second electrode 112 is electrically connected to the first conductive layer 123 through a conductive channel formed by the second via 152.

It should be understood that the etching process may include at least one of the following processes: a dry etching process, a wet etching process or a laser etching process.

Further, the dry etching (dry etching) process may include at least one of the following etching processes: reactive ion etching (reactive ion etching), ion beam etching (ion beam etching), or the like. A chemical raw material of the wet etching process may include, but is not limited to, an etching solution containing hydrofluoric acid. In some embodiments of the present application, an etching method combining dry etching with wet etching is adopted, or an etching method combining laser etching with wet etching is adopted, which could effectively ensure the etched shape and the flatness of the bottom surface, or the like.

The deposition process includes, but is not limited to:
a physical vapor deposition (Physical Vapor Deposition, PVD) process and/or a chemical vapor deposition (Chemical Vapor Deposition, CVD) process. For example, thermal oxidation, plasma enhanced chemical vapor deposition (Plasma Enhanced Chemical Vapor Deposition, PECVD), low pressure chemical vapor deposition (Low Pressure Chemical Vapor Deposition, LPCVD), or the like), atomic layer deposition (Atomic layer deposition, ALD), electroplating, spin coating or spray coating.

It should also be understood that the method embodiment and the product embodiment may correspond to each other, and similar descriptions may refer to the product embodiment. For the sake of brevity, they will not be repeatedly described here.

It should also be understood that FIGS. 1 to 5 are only examples of the present application, and should not be understood as limitation to the present application.

For example, in other alternative embodiments, the process of producing the conductive region may be directly omitted. That is, the dielectric layer is directly produced on the conductive substrate.

It should also be understood that, each embodiment of the method 300 for producing the capacitive apparatus listed above may be executed by a robot or numerical control machine. The device software or process for executing the method 300 may execute the foregoing method 300 by executing the computer program code stored in the memory.

It shall be noted that each embodiment described in the present application and/or the technical features in each embodiment can be combined with each other arbitrarily in the case of no conflict, and the technical solutions obtained after combination should also fall into the protection scope of the present application.

It should be understood that sequence numbers of the foregoing processes do not mean execution sequences in various embodiments of the present application. The execution sequences of the processes should be determined according to functions and internal logic of the processes, and should not be construed as any limitation on the implementation processes of the embodiments of the present application.

An ordinary person skilled in the art may be aware that the preparation method described in conjunction with the embodiments disclosed herein can be implemented by electronic hardware or a combination of computer software and electronic hardware. Whether these functions are implemented in the form of hardware or software depends upon a particular application of the technical solutions and constraint conditions of design. A person skilled in the art may use different methods to implement the described functions for each particular application, but it should not be considered that the implementation goes beyond the scope of the present application.

In several embodiments provided by the present application, it should be understood that the disclosed integrated apparatus, the components in the integrated apparatus and the method for producing the integrated apparatus may be realized in other manners. For example, the embodiments of the integrated apparatus described above are only exemplary. For example, the division of layers is just a division of logical functions, and there may be other division manners for practical implementations. For example, multiple layers or devices may be combined or integrated, and for example, the upper plate and the active material layer may be combined into one layer. Or some features (such as the active material layer) may be omitted or not produced.

The foregoing descriptions are merely specific embodiments of the present application, however, the protection scope of the present application is not limited thereto, persons skilled in the art who are familiar with the art could readily think of variations or substitutions within the technical scope disclosed by the present application, and these variations or substitutions shall fall within the protection scope of the present application. Therefore, the protection scope of the present application shall be subject to the protection scope of the claims.

## Claims

1. A capacitive apparatus, comprising:

   at least one capacitor;
   wherein the at least one capacitor comprises at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient.

2. The capacitive apparatus according to claim 1, wherein the positive voltage coefficient of the first dielectric layer and the negative voltage coefficient of the second dielectric layer enable a voltage coefficient of the at least one capacitor to be zero or close to zero; and/or the positive temperature coefficient of the first dielectric layer and the negative temperature coefficient of the second dielectric layer enable a temperature coefficient of the at least one capacitor to be zero or close to zero.

3. The capacitive apparatus according to claim 1 or 2, wherein the at least one capacitor comprises:

   at least two capacitors connected in parallel; wherein the at least two capacitors comprise at least one first capacitor and at least one second capacitor, and the first capacitor has a positive voltage coefficient and the second capacitor has a negative voltage coefficient, so that a voltage coefficient of the at least two capacitors is zero or close to zero; and/or the first capacitor has a positive temperature coefficient and the second capacitor has a negative temperature coefficient, so that a temperature coefficient of the at least two capacitors is zero or close to zero.

4. The capacitive apparatus according to claim 3, wherein the first dielectric layer comprises a first silicon dioxide, $SiO_2$, layer, a second $SiO_2$ layer and a first hafnium oxide, $HfO_2$, layer, wherein the first $HfO_2$ layer is disposed between the first $SiO2$ layer and the second $SiO_2$ layer; and the second dielectric layer comprises a third $SiO_2$ layer, a fourth $SiO_2$ layer and an yttrium oxide, $Y_2O_3$, layer, wherein the $Y_2O_3$ layer is disposed between the third $SiO_2$ layer and the fourth $SiO_2$ layer.

5. The capacitive apparatus according to claim 3 or 4, wherein a number of the at least one first capacitor is equal to a number of the at least one second capacitor.

6. The capacitive apparatus according to any one of claims 1 to 5, wherein the at least one capacitor comprises:
   a third capacitor, wherein dielectric layers of the third capacitor comprise the first dielectric layer and the second dielectric layer, so that a voltage coefficient and/or a temperature coefficient of the third capacitor is zero or close to zero.

7. The capacitive apparatus according to claim 6, wherein the first dielectric layer comprises a fifth silicon dioxide, $SiO_2$, layer and a sixth $SiO_2$ layer, and the second dielectric layer comprises a second hafnium dioxide, $HfO_2$, layer, wherein the second $HfO_2$ layer is disposed between the fifth $SiO_2$ layer and the sixth $SiO_2$ layer.

8. The capacitive apparatus according to any one of claims 1 to 7, wherein the at least one capacitor is at least one capacitor formed by a laminated structure.

9. The capacitive apparatus according to claim 8, wherein the laminated structure comprises:

a plurality of dielectric layers and at least one conductive layer that are disposed above a substrate;
wherein the plurality of dielectric layers and the at least one conductive layer form a structure that a dielectric layer and a conductive layer are adjacent to each other.

10. The capacitive apparatus according to claim 9, wherein the substrate is a conductive substrate, or a surface of the substrate close to the laminated structure is provided with a conductive region with a resistivity lower than a preset threshold value, and a bottom layer of the laminated structure close to the substrate is a dielectric layer in the plurality of dielectric layers.

11. The capacitive apparatus according to claim 9, wherein the substrate is an insulating substrate, and a bottom layer of the laminated structure close to the substrate is a conductive layer in the at least one conductive layer.

12. The capacitive apparatus according to any one of claims 9 to 11, wherein a surface of the substrate close to the laminated structure is provided with at least one groove, and at least a portion of the laminated structure is disposed in the at least one groove.

13. The capacitive apparatus according to any one of claims 9 to 12, wherein a bottom conductive layer of the at least one conductive layer close to the substrate or a bottom dielectric layer of the plurality of dielectric layers close to the substrate forms at least one of following structures:
a trench structure, a pillar structure, or a wall structure.

14. A method for producing a capacitive apparatus, comprising:

producing at least one capacitor;
wherein the at least one capacitor comprises at least one first dielectric layer and at least one second dielectric layer, the first dielectric layer has a positive voltage coefficient and the second dielectric layer has a negative voltage coefficient; and/or the first dielectric layer has a positive temperature coefficient and the second dielectric layer has a negative temperature coefficient.

15. The method according to claim 14, wherein the positive voltage coefficient of the first dielectric layer and the negative voltage coefficient of the second dielectric layer enable a voltage coefficient of the at least one capacitor to be zero or close to zero; and/or the positive temperature coefficient of the first dielectric layer and the negative temperature coefficient of the second dielectric layer enable a temperature coefficient of the at least one capacitor to be zero or close to zero.

16. The method according to claim 14 or 15, wherein the producing at least one capacitor comprises:

producing at least two capacitors connected in parallel;
wherein the at least two capacitors comprise at least one first capacitor and at least one second capacitor, and the first capacitor has a positive voltage coefficient and the second capacitor has a negative voltage coefficient, so that a voltage coefficient of the at least two capacitors is zero or close to zero; and/or the first capacitor has a positive temperature coefficient and the second capacitor has a negative temperature coefficient, so that a temperature coefficient of the at least two capacitors is zero or close to zero.

17. The method according to claim 16, wherein the first dielectric layer comprises a first silicon dioxide, $SiO_2$, layer, a second $SiO_2$ layer and a first hafnium oxide, $HfO_2$, layer, wherein the first $HfO_2$ layer is disposed between the first $SiO_2$ layer and the second $SiO_2$ layer; and the second dielectric layer comprises a third $SiO_2$ layer, a fourth $SiO_2$ layer and an yttrium oxide, $Y_2O_3$, layer, wherein the $Y_2O_3$ layer is disposed between the third $SiO_2$ layer and the fourth $SiO_2$ layer.

18. The method according to claim 16 or 17, wherein a number of the at least one first capacitor is equal to a number of the at least one second capacitor.

19. The method according to any one of claims 14 to 18, wherein the producing at least one capacitor comprises:
producing a third capacitor, wherein dielectric layers of the third capacitor comprise the first dielectric layer and the second dielectric layer, so that a voltage coefficient and/or a temperature coefficient of the third capacitor is zero or close to zero.

20. The method according to any one of claims 14 to 19, wherein the first dielectric layer comprises a fifth silicon dioxide, $SiO_2$, layer and a sixth $SiO_2$ layer, and the second dielectric layer comprises a second hafnium dioxide, $HfO_2$, layer, wherein the second $HfO_2$ layer is disposed between the fifth $SiO_2$ layer and

the sixth $SiO_2$ layer.

21. The method according to any one of claims 14 to 20, wherein the at least one capacitor is at least one capacitor formed by a laminated structure.

22. The method according to claim 21, wherein the producing at least one capacitor comprises:

producing a plurality of dielectric layers and at least one conductive layer that are disposed above a substrate;
wherein the plurality of dielectric layers and the at least one conductive layer form a structure that a dielectric layer and a conductive layer are adjacent to each other.

23. The method according to claim 22, wherein the substrate is a conductive substrate, or a surface of the substrate close to the laminated structure is provided with a conductive region with a resistivity lower than a preset threshold value, and a bottom layer of the laminated structure close to the substrate is a dielectric layer in the plurality of dielectric layers.

24. The method according to claim 22, wherein the substrate is an insulating substrate, and a bottom layer of the laminated structure close to the substrate is a conductive layer in the at least one conductive layer.

25. The method according to any one of claims 22 to 24, wherein a surface of the substrate close to the laminated structure is provided with at least one groove, and at least a portion of the laminated structure is disposed in the at least one groove.

26. The method according to any one of claims 22 to 25, wherein a bottom conductive layer of the at least one conductive layer close to the substrate or a bottom dielectric layer of the plurality of dielectric layers close to the substrate forms at least one of following structures:
a trench structure, a pillar structure, or a wall structure.

27. A capacitive apparatus, comprising:
the capacitive apparatus produced by the method according to any one of claims 14 to 26.

<u>100</u>

121

111    122    112

151

152
123
140    124

131

130

FIG. 1

210

220

FIG. 2

C

$C_1+C_2$

$C_2$

$C_1$

V

FIG. 3

100

121

111
122

112

151

140

152

123

131

130

124 { 1241
1242
1243

FIG. 4

FIG. 5

<u>300</u>

| | |
|---|---|
| Forming a conductive region on an upper surface of a substrate | 310 |
| Depositing a first dielectric layer and a first conductive layer on the conductive region | 320 |
| Depositing a second dielectric layer and a second conductive layer on the first conductive layer | 330 |
| Forming a step of the first conductive layer and a step of the second conductive layer | 340 |
| Depositing an insulating layer above the substrate, and forming a plurality of vias in the insulating layer | 350 |
| Filling a conductive material in the plurality of vias, and forming at least two electrodes above the plurality of vias | 360 |

FIG. 6

131
130

FIG. 7

123
124
131
130

FIG. 8

121    122

123
124
131

130

FIG. 9

121    122

123
124
131

130

FIG. 10

FIG. 11

## INTERNATIONAL SEARCH REPORT

| International application No. |
|---|
| **PCT/CN2019/098020** |

**A.    CLASSIFICATION OF SUBJECT MATTER**

　　H01L 27/04(2006.01)i;　H01L 21/02(2006.01)n

According to International Patent Classification (IPC) or to both national classification and IPC

**B.    FIELDS SEARCHED**

Minimum documentation searched (classification system followed by classification symbols)

　　H01L27/-,　H01L21/-,　H01G11/-

Documentation searched other than minimum documentation to the extent that such documents are included in the fields searched

Electronic data base consulted during the international search (name of data base and, where practicable, search terms used)

　　CNABS, CNTXT, DWPI, SIPOABS, CNKI: 电容, 层, 电压, 系数, 温度, 正, 负, 槽, capacitor, layer, voltage, coefficient, temperature, positive, negative, groove

**C.    DOCUMENTS CONSIDERED TO BE RELEVANT**

| Category* | Citation of document, with indication, where appropriate, of the relevant passages | Relevant to claim No. |
|---|---|---|
| X | CN 109817607 A (TAIWAN SEMICONDUCTOR MANUFACTURING COMPANY LIMITED) 28 May 2019 (2019-05-28) description, paragraphs 21-110, figures 1-7 | 1-27 |
| A | CN 1992268 A (TAIWAN SEMICONDUCTOR MANUFACTURING COMPANY LIMITED) 04 July 2007 (2007-07-04) entire document | 1-27 |
| A | CN 108259040 A (BEIJING SMARTCHIP MICROELECTRONICS TECHNOLOGY COMPANY LIMITED et al.) 06 July 2018 (2018-07-06) entire document | 1-27 |
| A | CN 101673741 A (SEMICONDUCTOR COMPONENTS INDUSTRIES LLC) 17 March 2010 (2010-03-17) entire document | 1-27 |
| A | JP H06204405 A (NISSAN MOTOR) 22 July 1994 (1994-07-22) entire document | 1-27 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **21 April 2020** | **28 April 2020** |

| Name and mailing address of the ISA/CN | Authorized officer |
|---|---|
| **China National Intellectual Property Administration (ISA/ CN)** **No. 6, Xitucheng Road, Jimenqiao Haidian District, Beijing 100088** **China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2019/098020**

| Patent document cited in search report | | | Publication date (day/month/year) | Patent family member(s) | | | Publication date (day/month/year) |
|---|---|---|---|---|---|---|---|
| CN | 109817607 | A | 28 May 2019 | KR | 20190058263 | A | 29 May 2019 |
| | | | | TW | I662569 | B | 11 June 2019 |
| | | | | US | 2019157378 | A1 | 23 May 2019 |
| | | | | TW | 201926376 | A | 01 July 2019 |
| | | | | DE | 102018108908 | A1 | 23 May 2019 |
| CN | 1992268 | A | 04 July 2007 | TW | 200725917 | A | 01 July 2007 |
| | | | | US | 2007152295 | A1 | 05 July 2007 |
| | | | | TW | I358135 | B | 11 February 2012 |
| | | | | US | 7763923 | B2 | 27 July 2010 |
| CN | 108259040 | A | 06 July 2018 | None | | | |
| CN | 101673741 | A | 17 March 2010 | CN | 101673741 | B | 23 March 2016 |
| | | | | US | 2010059849 | A1 | 11 March 2010 |
| | | | | TW | I500168 | B | 11 September 2015 |
| | | | | HK | 1141138 | A1 | 16 June 2017 |
| | | | | TW | 201011920 | A | 16 March 2010 |
| | | | | US | 9000550 | B2 | 07 April 2015 |
| JP | H06204405 | A | 22 July 1994 | None | | | |

Form PCT/ISA/210 (patent family annex) (January 2015)